(19) Europäisches Patentamt
European Patent Office
Office européen des brevets

(11) **EP 1 302 782 B1**

(12) **EUROPÄISCHE PATENTSCHRIFT**

(45) Veröffentlichungstag und Bekanntmachung des Hinweises auf die Patenterteilung:
**21.03.2007 Patentblatt 2007/12**

(51) Int Cl.:
***G01R 33/54*** *(2006.01)*

(21) Anmeldenummer: **02021609.9**

(22) Anmeldetag: **27.09.2002**

(54) **Bildgebendes Mehrschicht-Verfahren der Magnetresonanz (NMR) mittels Homogenous Preparation Encoding (HoPE)**

MR multi-slice imaging with Homogenous Preparation Encoding (HoPE)

Procédé d'IRM multi-couches avec Homogenous Preparation Encoding (HoPE)

(84) Benannte Vertragsstaaten:
**AT BE BG CH CY CZ DE DK EE ES FI FR GB GR IE IT LI LU MC NL PT SE SK TR**

(30) Priorität: **11.10.2001 DE 10150133**

(43) Veröffentlichungstag der Anmeldung:
**16.04.2003 Patentblatt 2003/16**

(73) Patentinhaber: **Universitätsklinikum Freiburg**
**79106 Freiburg (DE)**

(72) Erfinder: **Fautz, Hans-Peter**
**79111 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
**US-A- 5 633 586         US-A- 5 729 138**

- **A.H. HERLIHY ET AL.: "FLAIR Imaging ..." MAGNETIC RESONANCE IN MEDICINE, Bd. 46, August 2001 (2001-08), Seiten 354-364, XP002229624**
- **TH. ERNST, J. HENNIG: "Improved Water Suppression ..." JOURNAL OF MAGNETIC RESONANCE, SERIES B, Bd. 106, 1995, Seiten 181-186, XP002229625**

EP 1 302 782 B1

**Beschreibung**

Die Erfindung betrifft ein bildgebendes Mehr-Schicht-Verfahren der Magnetresonanz (=NMR) zur Aufnahme von N Schichten (N>1) aus einem Messobjekt, bei welchem zur vollständigen Bildrekonstruktion eine Aufnahme in m (m > 1) Wiederholschritten mit jeweils unterschiedlicher Ortskodierung verwendet wird, mit einer Magnetisierungspräparation in Form eines bezüglich der chemischen Verschiebung (=chemical shift) selektiven Sättigungspulses, der in jedem Wiederholschritt P mal (1 ≤ P < N) appliziert wird, so dass durch jeden dieser chemical shift selektiven Sättigungspulse das Signal mit dem entsprechenden chemical shift in jeweils einer Scheibe vollständig unterdrückt wird und demzufolge die Signale von N-P Schichten nur unvollständig gesättigt werden.

Ein solches Verfahren ist beispielsweise bekannt aus der in der anhängenden Literaturliste unter [2] aufgeführten Publikation von Rosen BR, Wedeen VJ, Brady TJ. "Selective saturation NMR imaging", J Comput Assist Tomogr; 8:813-818; 1984.

In der bildgebenden Kernspintomografie werden zwei-dimensionale Scheibenbilder von einem zu untersuchenden Objekt gewonnen. Zur Abbildung eines Volumens werden Sätze von parallelen Scheiben aufgenommen, die die Raumrichtung orthogonal zu diesen Scheiben aufspannen.

Für die Aufnahme eines Bildes sind im Allgemeinen m Teilschritte erforderlich, in denen jeweils n komplexe Datenpunkte aufgenommen werden. Die Bildrekonstruktion aus den $m \times n$ Datenpunkten erfolgt mittels einer zweidimensionalen Fouriertransformation (2DFT). Zwischen zwei Teilschritten, den sogenannten Phasenkodierschritten (=PK-Schritten), wird jeweils das magnetische Feld durch zeitlich veränderliche Magnetfeldgradienten variiert. Im Allgemeinen wird eine Scheibe zur Aufnahme mehrerer PK-Schritte mehrfach angeregt. Die Zeit zwischen zwei Anregungen, die sogenannte Wiederholzeit TR, liegt in der Größenordnung der NMR Relaxationszeiten und bestimmt den Bildkontrast.

Mit Hilfe von frequenzselektiven (schmalbandigen) HF-Pulsen, die unter einem konstanten Magnetfeldgradienten eingestrahlt werden, können selektiv Scheiben einer gewissen Dicke angeregt werden. Mehrschicht (=Multi-Slice) Bildgebung wird eine Klasse von Methoden genannt, die innerhalb einer Wiederholzeit TR nacheinander eine Anzahl von N Scheiben anregen und auslesen. Bei jedem Wiederholungsschritt werden alle Scheiben in der jeweils gleichen Reihenfolge angeregt. Die Ortskodierung ist von Wiederholungsschritt zu Wiederholungsschritt unterschiedlich [1]. Der zeitliche Abstand zwischen zwei aufeinanderfolgenden Anregungen der gleichen Scheibe ist für alle Scheiben gleich der Wiederholzeit $TR = N * TA$, wenn TA die für die Aufnahme eines PK-Schrittes benötigte Zeit ist. In der nahezu gleichen Aufnahmezeit, die für die Aufnahme einer Scheibe benötigt wird, werden alle N Scheiben aufgenommen.

Die in Fettmolekülen eingebunden Protonen unterscheiden sich in ihrer Lamorfrequenz um 3,4 ppm von den freien bzw. in Wasser gebundenen Protonen. Durch diese sogenannte chemische Verschiebung (=chemical shift) ist es prinzipiell möglich, getrennte Wasser- bzw. Fettbilder zu erzeugen, die jeweils nur eine der zwei spektralen Komponenten enthalten. Eine verbreitete Methode, Wasserbilder zu erhalten, ist die sogenannte Fettsättigung mit Hilfe von chemical shift selektiven HF-Pulsen.

Unmittelbar vor einer räumlich (Schicht-) selektiven Anregung wird mit Hilfe eines chemical shift selektiven Pulses die Magnetisierung der Fettmoleküle in die transversale Ebene ausgelenkt und durch Gradientenpulse gespoilt. Nach dieser Präparation, bestehend aus der Applikation von einem Fettsättigungspuls und Spoilergradienten erfolgt die Scheibenanregung auf beide spektrale Komponenten und die eigentliche Datenaufnahme des überbleibenden Wassersignals [2].

Für die meisten Sequenzen wird die Fettsättigungspräparation unmittelbar vor jeder Spinecho- oder Gradientenechoaufnahme platziert. Andere Techniken wie fettgesättigte, multiple Spinecho Sequenzen lesen nach nur einer Präparation größere Teile des k-Raumes aus [3].

Für Multi-Slice Aufnahmen verwendet man auch eine schnellere Variante. Man verzichtet darauf, vor jeder Aufnahme eines PK-Schrittes jeder Scheibe eine Fettsättigungspräparation zu applizieren. Zu Beginn jeder Wiederholung wird nur eine Präparation appliziert. Anschließend werden alle Scheiben nacheinander angeregt, bevor in einer folgenden Wiederholzeit die nächste Präparation angewandt wird. Ein Satz von Wasser- oder Fettbildern kann damit in der näherungsweise gleichen Zeit aufgenommen werden wie die entsprechenden kombinierten Bilder [2,4,5].

Der zeitliche Abstand zwischen der Präparation und der Anregung einer bestimmten Scheibe ist für die verschiedenen Scheiben unterschiedlich. Für unterschiedliche Zeiten erfährt die durch die Fettsättigungspräparation ausgelenkte Magnetisierung unterschiedliche longitudinale Ausrichtung durch T1-Relaxation. Jede Scheibe wird in einem anderen Präparationszustand aufgenommen. Die Fettunterdrückung kann nur für eine Scheibe optimiert werden, indem diese Scheibe zu dem Zeitpunkt innerhalb der Wiederholzeit angeregt wird, wenn die longitudinale Magnetisierung der Fettprotonen Null ist. Die anderen Scheiben zeigen entsprechend der T1-Relaxation und der Reihenfolge der Scheibenanregung eine reduzierte Fettunterdrückung.

US-A-5 729 138 beschreibt ein bildgebendes Mehrschichtaufnahmeverfahren, bei dem zur Unterdrückung des Fettsignals vor der Aufnahme unterschiedlich ortskodierter Signale chemical shift selektive Sättigungspulse angewendet werden. Es behandelt das Problem unterschiedlicher Fettsättigung in verschiedenen Scheiben aufgrund räumlicher Variation der Resonanzfrequenz der zu sättigenden Spins in einem inhomogenen Magnetfeld. Eine gleichmäßige Fettsättigung in allen Scheiben wird erzielt, indem die Kenngrößen des verwendeten Sättigungspulses (z.B. Frequenz, Phase) von Aufnahmeschritt zu Aufnahmeschritt variiert wird, um sie dem lokalen Feld in der diesem Aufnahmeschritt zugeordneten Schicht bestmöglich anzupassen. In dem aus US-A-5 729 138 bekannten Verfahren wird vor jedem der zu den verschiedenen Schichten gehörenden Aufnahmeschritte ein Sättigungspuls durchgeführt. Es reduziert Variationen in der Fettsättigung von Schicht zu Schicht, die auf räumliche Variationen des Magnetfeldes zurückzuführen sind. Das bekannte Verfahren ändert die Eigenschaften der verwendeten Sättigungspulse über die Aufnahme hinweg.

Aufgabe der vorliegenden Erfindung ist es demgegenüber, ein Verfahren der eingangs beschriebenen Art so zu verbessern, dass die oben diskutierten Nachteile vermieden werden können. Insbesondere soll die Erfindung eine neue Methode vorstellen mit dem Ziel einer für alle Scheiben gleichmäßigen Fett- bzw. Wasserunterdrückung.

Erfindungsgemäß wird diese Aufgabe auf wirkungsvolle Art und Weise dadurch gelöst, dass die zeitliche Aufeinanderfolge der Sättigungspulse und/oder die Reihenfolge der Aufnahme der unterschiedlich ortskodierten Signale der einzelnen Schichten so permutiert wird, dass nach Beendigung der Aufnahme für jede Schicht die Signale mit identischer Ortskodierung auch in Bezug auf die Sättigungspräparation in gleicher Weise aufgenommen wurden.

Teilweise wird dazu eine gegenüber dem Stand der Technik modifizierte Multi-Slice Aufnahmetechnik eingesetzt, die mit anderer Zielsetzung an sich bereits von Norris [6] und Herlihy [7] verwendet wurde. Sie ist auf alle üblichen Multi-Slice Methoden anwendbar.

Besonders bevorzugt ist eine Variante des erfindungsgemäßen Verfahrens, bei der eine Permutation der Reihenfolge der Aufnahme der unterschiedlich ortskodierten Signale der einzelnen Schichten durchgeführt wird, wobei das Schema der zeitlichen Abfolge zwischen Sättigungspulsen und der Aufnahme der Wiederholschritte über die gesamten m Wiederholschritte beibehalten wird, wobei jedoch die Abfolge der einzelnen Ortskodierschritte sowie der Zuordnung der N auf die einzelnen Schichten wirkenden Aufnahmen der unterschiedlich ortskodierten Signale zu den jeweiligen Schichten variiert werden.

Bei einer alternativen Verfahrensvariante wird eine Permutation der zeitlichen Aufeinanderfolge der Sättigungspulse durchgeführt , wobei die zeitliche Abfolge der unterschiedlich ortskodierten Signale der einzelnen Schichten über die m Aufnahmen der unterschiedlich ortskodierten Signale beibehalten und der Zeitpunkt der Anwendung der Sättigungspulse relativ zu den Aufnahmen der unterschiedlich ortskodierten Signale der einzelnen Schichten verschoben wird.

In einer besonders bevorzugten Variante des erfindungsgemäßen Verfahrens werden HF-Impulse eingestrahlt und zeitlich veränderliche Magnet-Gradientenfelder zur Ortskodierung nach dem Prinzip der ortsaufgelösten n-dimensionalen Fouriertransformationsmethode gewählt. Damit lassen sich aus den aufgenommen NMR-Signalen besonders einfach ortsaufgelöste Bilder rekonstruieren.

Bei einer einfachen Variante des erfindungsgemäßen Verfahrens werden klassische Spinecho-Sequenzen eingesetzt.

Eine weitere, vorteilhafte Verfahrensvariante zeichnet sich aus durch die Verwendung einer Gradientenechosequenz, welche entweder als spoiled-FLASH, refocused FLASH, reversed FLASH oder trueFISP ausgebildet sein kann.

Bei einer alternativen, ebenfalls vorteilhaften Variante des erfindungsgemäßen Verfahrens schließlich werden RARE(TSE)-Sequenzen angewandt, so dass in jedem Einzelschritt mehrere unterschiedlich ortskodierte Daten aufgenommen werden.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert.

Im Einzelnen zeigen die Abbildungen Folgendes:

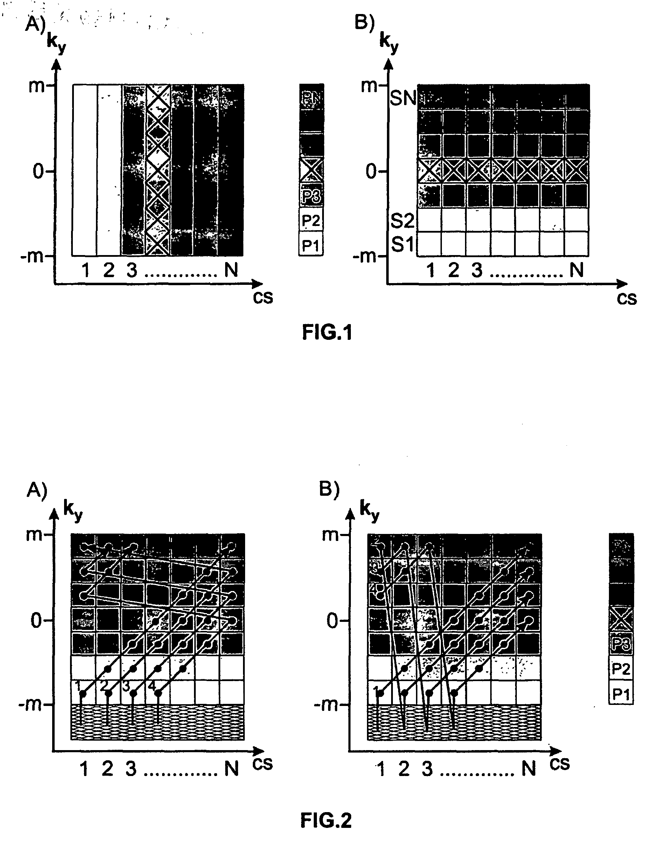

Fig.1   Präparationszustände der PK-Schritte in einer konventionellen (links) und einer HoPE (rechts) Multi-Slice Aufnahme. Die Präparationszustände P1, P2,....,PN sind grau kodiert. Nach der HoPE Aufnahmeordnung werden die PK-Schritte in N gleich große Segmente S1, S2,...., SN eingeteilt. Die Einteilung erfolgt typischerweise linear. Den Segmenten werden (hier linear) Präparationszustände zugeordnet. Der Präparationszustand, der den gewünschten Kontrast kodiert, ist mit einem X gekennzeichnet und wird dem mittleren k-Raumsegment zugeordnet.

Fig.2   Aufnahmetrajektorien für verschiedene Wiederholungen eines HoPE-Multi-Slice Experimentes. Die schwarzen Pfeile verbinden exemplarisch jeweils einen PK-Schritt aus jedem Segment in der zeitlichen Reihenfolge ihrer Aufnahme. Die applizierten Präparationen werden entsprechend ihren Applikationszeitpunkten durch die schraffierten Felder in die Trajektorie integriert. In dem links dargestellten Verfahren wird die Präparation nach jeweils N Aufnahmeschritten zu Beginn jeder Wiederholung appliziert. Die Reihenfolge der Scheibenanregungen innerhalb einer Wiederholung ändert sich über die Wiederholungen hinweg in der nummerierten Reihenfolge. In dem rechts dargestellten Verfahren bleibt die zeitliche Reihenfolge der Scheibenanregung innerhalb einer Wiederholung über alle Wiederholungen hinweg gleich. Der Zeitpunkt zu dem die Präparation innerhalb einer Wiederholung appliziert wird, ändert sich über die Wiederholungen hinweg in der angegebenen Reihenfolge.

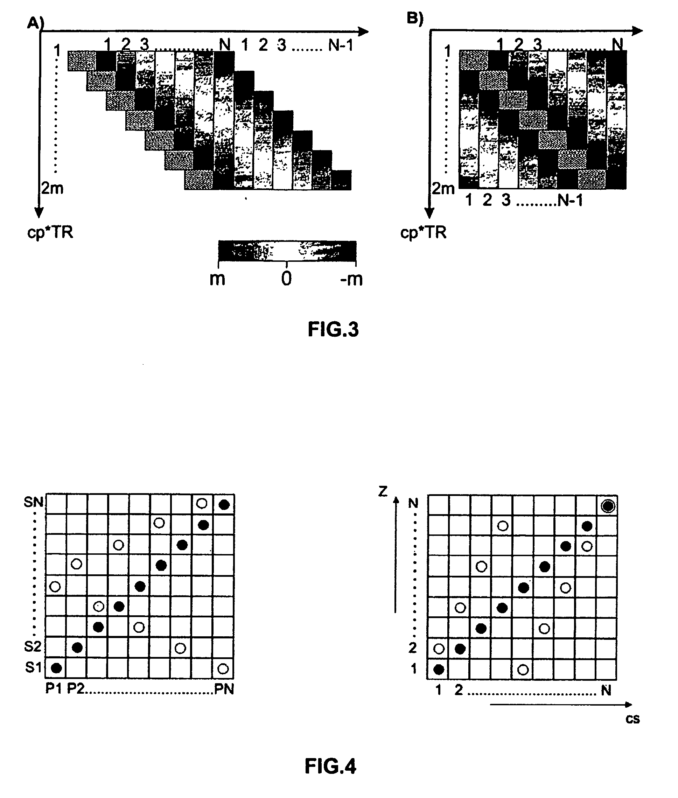

Fig. 3     Vollständige zeitliche Abläufe einer HoPE-Aufnahme. Die zeitliche Aufnahmeabfolge der grau kodierten PK-Schritte läuft von links nach rechts und von oben nach unten. Schraffierte Kästchen stellen die Präparationen dar. Fig.3A verwendet die in Fig.2A dargestellten Trajektorien. Die Reihenfolge der Scheibenanregung wird über die Wiederholungen hinweg permutiert. Fig.3B verwendet die in Fig.2B gezeigten Trajektorien.
Die Reihenfolge der Scheibenanregung bleibt für alle Wiederholungen gleich. Der Zeitpunkt der Präparation innerhalb der Wiederholung wird über die Wiederholungen hinweg verschoben.

Fig.4     Look-up-tables für die Zuordnung der Präparationszustände P1...PN zu den k-Raumsegmenten S1...SN (links) und des Scheibenzählers cs zu räumlichen Scheibenpositionen z (rechts), wobei die ausgefüllten Kreise in der linken Figur "linear", in der rechten Figur "kontinuierlich" und die nicht-ausgefüllten Kreise in der linken Figur "zentrisch", in der rechten Figur "interleaved" bedeuten.

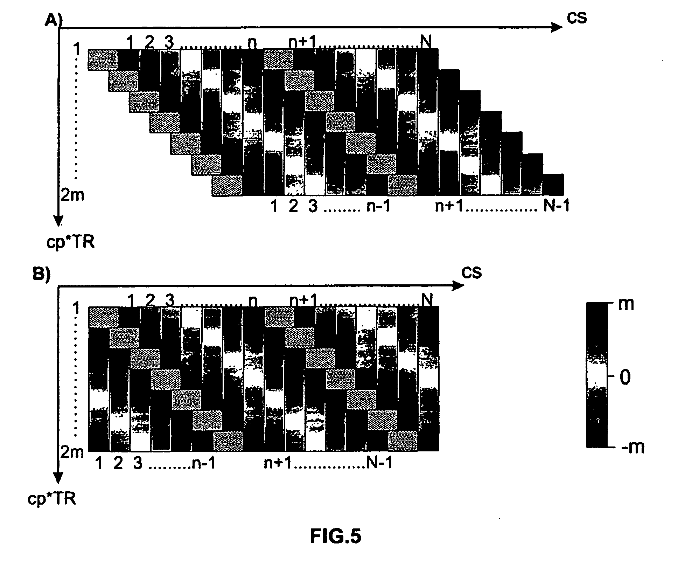

Fig.5     Verallgemeinerung der in Fig.3 dargestellten HoPE Technik auf ein Verfahren mit P Magnetisierungspräparationen pro Wiederholung. Die Aufnahmesequenz einer Aufnahme mit einer Präparation pro Wiederholung und n=N/P Scheiben (Figuren 3A und 3B) wird entsprechend (P-1)-fach in Scheibenrichtung kopiert.

In einem Multi-Slice Experiment mit N Scheiben gibt es N verschiedene Aufnahmezeitpunkte innerhalb einer Wiederholzeit. Bezüglich des zeitlichen Abstands zu einer chemical shift selektiven Sättigung entsprechen diese Aufnahmezeitpunkte N verschiedenen Präparationszuständen P1,P2,....,PN.

Nach dem konventionellen Aufnahmeschema haben alle PK-Schritte einer Scheibe den jeweils gleichen Präparationszustand (Fig.1A). Verschiedene Scheiben werden jedoch in verschiedenen Präparationszuständen aufgenommen. Damit hat jede Scheibe einen anderen Kontrast bezüglich der Präparation.

Die prinzipielle Idee von HoPE ist, identisch präparierte Signale für identische PK-Zeilen von verschiedenen Scheiben zu kodieren. Im Gegensatz zur konventionellen Methode müssen dazu gleiche PK-Schritte von verschiedenen Zeilen in verschiedenen Wiederholungen aufgenommen werden. Alle Scheiben haben unter der folgenden HoPE-Bedingung gleiche Bildeigenschaften bezüglich einer Fett- bzw. Wassersättigung. Alle PK-Schritte mit demselben $k_y$-Wert müssen für alle Scheiben den gleichen Präparationszustand haben. PK-Schritte mit dem gewünschten Präparationskontrast werden in der k-Raummitte kodiert (Fig. 1B).

Dazu müssen die 2m PK-Schritte -m,....,m in N Segmente S1,S2,....,SN eingeteilt werden, denen jeweils ein Präparationszustand zugeordnet wird. Da in jeder Wiederholung einer Multi-Slice Aufnahme jeder Präparationszustand einmal aufgenommen wird, werden alle Präparationszustände über die Wiederholungen hinweg gleich häufig aufgenommen. Die N Segmente sind daher alle gleich groß und enthalten jeweils m/N PK-Schritte.

Die HoPE-Bedingungen sind in Fig.1B graphisch zusammengefasst. Alle PK-Schritte eines Segmentes haben denselben Präparationszustand. Die PK-Schritte verschiedener Segmente haben verschiedene Präparationszustände. Alle PK-Schritte eines bestimmten $k_y$-Wertes haben für alle Scheiben den gleichen Präparationszustand. Die PK-Schritte des mittleren k-Raumsegmentes werden in dem Präparationszustand mit dem gewünschten Kontrast aufgenommen.

Um die HoPE- Bedingungen in einer Multi-Slice Sequenz umzusetzen müssen zwei Bedingungen für die Aufnahmereihenfolge der PK-Schritte erfüllt sein. Erstens müssen in jeder Wiederholung nacheinander alle Scheiben ausgelesen und damit in einem jeweils anderen Präparationszustand aufgenommen werden. Zweitens müssen nach 2m Wiederholungen alle PK-Schritte von allen Scheiben aufgenommen sein. Zeichnet man eine Trajektorie in Fig.1 B ein, die die in einer Wiederholung nacheinander aufgenommenen PK-Schritte verbindet, muss diese jeweils diagonal laufen, um die erste Bedingung zu erfüllen.

Es gibt zwei prinzipiell verschiedene Möglichkeiten, die Trajektorien zu wählen. Wird die chemical shift selektive Sättigung nach jeweils N Scheibenanregungen zu Beginn einer Wiederholung appliziert, wird für die verschiedenen Trajektorien die Reihenfolge der Scheibenanregung innerhalb einer Wiederholung permutiert (Fig. 2A).

Eine andere Möglichkeit besteht darin, die Reihenfolge der Scheibenanregungen innerhalb einer Wiederholung über die Wiederholungen hinweg konstant zu lassen. Dann muss der Applikationszeitpunkt der Präparation innerhalb einer Wiederholung über die Wiederholungen hinweg verschoben werden. Dies führt auf die in Fig.2B dargestellten Trajektorien.

Es sind auch Hybridversionen denkbar, die sowohl die Reihenfolge der Scheibenaufnahme permutieren als auch den Applikationszeitpunkt der Präparation verändern.

Die vollständigen zeitlichen HoPE-Sequenzen, die die zwei in Fig.2 dargestellten Verfahren A und B verwenden, sind entsprechend in den Figuren 3A und 3B dargestellt. Die zeitliche Achse der Aufnahme verläuft von links nach rechts und von oben nach unten. In beiden Sequenzen sind die Aufnahmebedingungen der Multi-Slice Technik (in jeder Wiederholung werden alle Scheiben aufgenommen und über die Wiederholungen hinweg werden jeweils alle PK-Schritte einer Scheibe vollständig aufgenommen) erfüllt.

In Verfahren A sind die HoPE-Bedingungen exakt, in Verfahren B nur annähernd erfüllt. In der Variante B haben die Segmente links der Präparation einen anderen Präparationszustand als die Segmente rechts der Präparation, die die gleichen PK-Schritte enthalten. Das Zeitintervall zwischen der chemical shift selektiven Sättigung und der Aufnahme eines PK-Schrittes unterscheidet sich in diesen Segmenten um die Aufnahmedauer TA eines PK-Schrittes, da sich das Zeitintervall auf die Präparation der vorangegangenen Wiederholung bezieht.

Die lineare Zuordnung der Präparationszustände zu den k-Raumsegmenten aus Fig.1B ist nur eine Möglichkeit. Allgemein kann jedem Präparationszustand ein beliebiges k-Raumsegment zugeordnet werden (Fig. 4; links). Kontraste können flexibel erzeugt werden, indem ein bestimmter Präparationszustand dem mittleren k-Raumsegment zugeordnet wird.

Auch die Zuordnung des Scheibenzählers cs zu den geometrischen Positionen der Schichten kann beliebig erfolgen (Fig.4; rechts). Damit sind alle üblichen Scheibenanregungsabfolgen, wie sie konventionell benutzt werden auch in der HoPE Technik verwendbar.

*Multiple Präparationen pro Wiederholung*

Um in allen Scheiben einer konventionellen Multi-Slice Aufnahme eine Kontrastmodifikation durch eine chemical shift selektive Sättigung zu erhalten, muss die Relaxationszeit der gesättigten Signale kürzer als das Zeitintervall zwischen zwei Präparationen sein. Bei einer T1-Zeit des Fettgewebes zwischen 150ms-200ms wird die Methode der einmaligen Fettpräparation pro Wiederholung nur bis zu Wiederholzeiten in der gleichen Größenordnung verwendet. In Spinechosequenzen, die typischerweise eine Wiederholzeit von ca. 500ms haben, wird dagegen unmittelbar vor jeder einzelnen Spinechoakquisition eine Fettsättigungspräparation angewandt. Dies verlängert i.A. die Gesamtmesszeit pro Scheibe beträchtlich.

Um die Zeit zwischen zwei Präparationen zu verkürzen, können auch mehrere äquidistante Präparationen innerhalb einer Wiederholzeit appliziert werden. Die Möglichkeit innerhalb einer Wiederholzeit P (P<N) Präparationen zu applizieren, ist im konventionellen Verfahren durch periodisch auftretende Signalmodulationen in Scheibenrichtung mit der Periodenlänge von N/P Scheiben begrenzt.

Die HoPE Bedingung für multiple Präparationen ist die gleiche wie für Einzelpräparation. Alle PK-Schritte mit demselben $k_y$-Wert müssen für alle Scheiben im selben Präparationszustand aufgenommen werden. Die Anzahl der möglichen Präparationszustände ist von N auf N/P reduziert. Die HoPE Bedingung kann für jeweils N/P Scheiben getrennt erfüllt werden. Damit ist das Problem auf den Einzelpräparationsfall zurückgeführt. In jeder Wiederholung werden N/P Scheiben in der gleichen Anzahl von verschiedenen Präparationszuständen ausgelesen. Die Lösung für diese N/P Scheiben kann für die anderen Paketen von N/P Scheiben kopiert werden, die in der gleichen Wiederholzeit aufgenommen werden.

Dies wird in Fig.5 graphisch dargestellt. Die mPK-Schritte werden in N/P Segmente eingeteilt, von denen jedes $P * \dfrac{m}{N}$ PK-Schritte enthält. Jedes Segment wird einem der N/P Präparationszustände zugeordnet. Für die ersten N/P Scheiben wird die HoPE- Bedingung analog zu Fig.3 erfüllt. Diese Lösung ist (P-1)-fach in Scheibenrichtung kopiert, um die gesamte N-Scheiben Sequenz zu erhalten.

*Vermeidung von Artefakten*

Zur Minimierung von Artefakten müssen möglichst glatte Signalverläufe in PK-Richtung gewährleistet werden. Dies gilt sowohl für den Signalverlauf aufgrund einer Magnetisierungspräparation als auch für den Signalverlauf aufgrund der verwendeten Wiederholzeiten zwischen zwei Anregungen derselben Scheibe. Der maximal glatte Verlauf von präparierten Signalen wird durch eine lineare Phasenkodierung erzeugt. Dadurch wird die Anzahl der Sprünge in den Signalintensitäten entlang der PK-Richtung auf N-1 minimiert. Diese entstehen an den Übergängen von einem Segment in ein anderes. Die Größe der Sprünge wird dadurch minimiert, dass benachbarte Segmente zeitlich benachbarten Präparationszuständen zugeordnet sind. Durch eine lineare Zuordnung wird diese Bedingung exakt erfüllt.

Für ein konventionelles Multi-Slice Experiment gilt für alle PK-Schritte einer Scheibe *TR = N \* TA + TP.* Dabei ist TA die für die Aufnahme eines PK-Schrittes und TP die für die Präparation benötigte Zeit. Signale aus den ersten Anregungen einer Scheibe werden für alle Scheiben linear vom k-Raumrand nach innen kodiert, um Artefakte aufgrund initialer Signalschwankungen zu minimieren.

Mit der neuen Aufnahmeordnung werden in den ersten Wiederholungen für einige Scheiben auch zentrumsnahe PK-Schritte aufgenommen (Fig.3A und Fig. 3B). Um Artefakte in diesen Scheiben zu vermeiden, müssen vor der eigentlichen Aufnahme einige sogenannte Dummyechos erzeugt werden. Dies sind Echos, die nicht für die Bildrekonstruktion verwendet werden.

Für Wiederholzeiten von typischerweise mehr als 50ms erreicht das Signal für die meisten Gewebe seine Gleichgewichtsamplitude nach wenigen TR-Intervallen. Durch diese Magnetisierungspräparation werden Signalschwankungen in den aufgenommenen PK-Schritten vermieden.

Auch für die nachfolgend aufgenommenen PK-Schritte ist die Bedingung einer konstanten Wiederholzeit nicht exakt zu erfüllen. Bei einem Wechsel der Scheibenabfolge oder des Applikationszeitpunktes der Präparation verändern sich die TR-Intervalle zwischen den zwei Anregungen der gleichen Scheibe (Figuren 3A und Fix.3B).

Mit dem Verfahren aus Fig.3B sind die Wiederholzeiten für alle Scheiben entlang der PK-Richtung konstant außer für den jeweils ersten PK-Schritt in den Spalten unterhalb eines Präparationsblockes. Diese haben eine um TP verkürzte Wiederholzeit $TR = N * TA$. Sie werden für alle Scheiben für den Rand des k-Raumes kodiert, was die Artefakte durch die längeren TR-Intervalle minimiert.

Mit dem Verfahren aus Fig.3A haben die PK-Schritte nach jedem Wechsel der Scheibenabfolge für alle Scheiben eine andere Wiederholzeit als in den übrigen Wiederholungen. Die ersten N-1 PK-Schritte in der ersten Wiederholung nach einem Wechsel in der Scheibenabfolge haben eine um TA verkürzte Wiederholzeit $TR = (N-1) * TA + TP$. Sie werden jeweils am Rand eines Segmentes kodiert. Der relative Unterschied in den Wiederholzeiten $\Delta TR/TR$ zwischen den ersten und folgenden PK-Schritten eines Segmentes beträgt

$$\frac{\Delta TR}{TR} = \frac{TA}{(N*TA)+TP} < \frac{1}{N}.$$ Für Multi-Slice Experimente mit typischerweise $N > 10$ Scheiben ist dieser Unterschied in guter Näherung vernachlässigbar.

Der PK-Schritt der - nach einem Wechsel der Scheibenabfolge - jeweils rechts äußeren Scheibe hat eine Wiederholzeit von $TR = (2N-1) * TA + TP$. Dieser wird für alle Scheiben am Rand des k-Raums kodiert, wodurch Artefakte minimiert werden.

Auftretende Signalunterschiede zwischen den ersten und folgenden Echos der Segmente können gegebenenfalls zusätzlich reduziert werden, indem analog zum Beginn der Aufnahme vor der Aufnahme von PK-Schritten mit abweichenden TR-Intervallen Dummywiederholungen eingebaut werden.

**Literaturliste:**

[1] Vlaardingerbroek, den Boer,
Magnetic Resonance Imaging,
Springer, 80f, 1999

[2] Rosen BR, Wedeen VJ, Brady TJ.
Selective saturation NMR imaging.
J Comput Assist Tomogr; 8:813-818; 1984

[3] Semelka RC, Chew W, Hricak H, Tomei E, Higgins CB.
Fat-saturation MR imaging of the upper abdomen.
AJR Am J Roentgenol; 155: 1111 1116; 1990

[4] Brateman L.,
Chemical Shift Imaging: A Review,
AJR 146:971-980; 1986

[5] Bottomley P.A., Foster TH, Leue WM,
In vivo nuclear magnetic resonance chemical shift imaging by selective irradiation.
Proc. Natl. Acad. Sci. USA, 81: 6856-6860; 1984

[6] Norris DG,
Reduced power multislice MDEFT imaging.
J Magn Reson Imaging 11 :445-451; 2000

[7] Herlihy AH, Oatridge A, Curati WL, Puri PK, Bydder GM, Hajnal JV. FLAIR Imaging Using Nonselective Inversion Pulses Combined With Slice Excitation Order Cycling and k-Space Reordering to Reduce Flow Artifacts.
MRM 46 :354-364; 2001

**Patentansprüche**

1. Bildgebendes Mehr-Schicht-Verfahren der Magnetresonanz (=NMR) zur Aufnahme von N Schichten (N>1)aus einem Messobjekt, bei welchem zur vollständigen Bildrekonstruktion eine Aufnahme in m (m > 1) Wiederholschritten mit jeweils unterschiedlicher Ortskodierung verwendet wird, mit einer Sättigungspräparation in Form eines bezüglich der chemischen Verschiebung (=chemical shift) selektiven Sättigungspulses, der in jedem Wiederholschritt P mal ($1 \leq P < N$) appliziert wird, so dass durch jeden dieser P chemical shift selektiven Sättigungspulse das Signal mit dem entsprechenden chemical shift in jeweils einer Scheibe vollständig unterdrückt wird und demzufolge die Signale von N-P Schichten nur unvollständig gesättigt werden,
**dadurch gekennzeichnet,**
**dass** die zeitliche Aufeinanderfolge der Sättigungspulse und/oder die Reihenfolge der Aufnahme der unterschiedlich ortskodierten Signale der einzelnen Schichten permutiert wird, wobei Signale mit identischer Ortskodierung für jede Schicht im gleichen Zustand der Sättigungspräparation aufgenommen werden.

2. Verfahren nach Anspruch 1, **dadurch gekennzeichnet, dass** eine Permutation der Reihenfolge der Aufnahme der unterschiedlich ortskodierten Signale der einzelnen Schichten durchgeführt wird, wobei das Schema der zeitlichen Abfolge zwischen Sättigungspulsen und der Aufnahme der Wiederholschritte über die gesamte m Wiederholschritte beibehalten wird, wobei jedoch die Abfolge der einzelnen Ortskodierschritte sowie der Zuordnung der N auf die einzelnen Schichten wirkenden Aufnahmen der unterschiedlich ortskodierten Signale zu den jeweiligen Schichten variiert werden.

3. Verfahren nach Anspruch 1, **dadurch gekennzeichnet, dass** eine Permutation der zeitlichen Aufeinanderfolge der Sättigungspulse durchgeführt wird, wobei die zeitliche Abfolge der Aufnahme der unterschiedlich ortskodierten Signale der einzelnen Schichten über die m Aufnahmen der unterschiedlich ortskodierten Signale beibehalten wird und der Zeitpunkt der Anwendung der Sättigungspulse relativ zu den Aufnahmen der unterschiedlich ortskodierten Signale der einzelnen Schichten verschoben wird.

4. Verfahren nach einem der vorhergehenden Ansprüche, **dadurch gekennzeichnet, dass** HF-impulse und zeitlich veränderliche Magnet-Gradientenfelder zur Ortskodierung nach dem Prinzip der n-dimensionalen ortsaufgelösten Fourier Transformationsmethode gewählt werden.

5. Verfahren nach einem der Ansprüche 1 bis 4, **gekennzeichnet durch** die Verwendung von Spinecho-Sequenzen.

6. Verfahren nach einem der vorhergehenden Ansprüche, **gekennzeichnet durch** die Verwendung einer Gradientenechosequenz, welche entweder als spoiled-FLASH, refocused FLASH, reversed FLASH oder trueFISP ausgebildet sein kann.

7. Verfahren nach einem der Ansprüche 1 bis 4, **gekennzeichnet durch** die Verwendung von RARE (TSE)-Sequenzen, so dass in jedem Einzelschritt mehrere unterschiedlich ortskodierte Daten aufgenommen werden.

## Claims

1. Nuclear magnetic resonance (NMR) multi-slice imaging method for recording N slices (N>1) from a measuring object, wherein for complete image reconstruction, an acquisition is used with m (m>1) repetition steps with different spatial encoding in each case, with a saturation preparation in the form of a saturation pulse which is selective with respect to the chemical shift and which is applied P times (1≤P<N) in each repetition step, such that through each of these P chemical shift-selective saturation pulses, in each case the signal with the corresponding chemical shift in one slice is completely suppressed and accordingly the signals of N-P slices are not completely saturated, **characterized in that** the chronological order of the saturation pulses and/or the sequence of the acquisition of the differently spatially encoded signals of the individual slices is permuted, wherein signals with identical spatial encoding are acquired for each slice in the same state of saturation preparation.

2. Method according to claim 1, **characterized in that** a permutation of the sequence of acquisition of the differently spatially encoded signals of the individual slices is carried out, wherein the scheme of the chronological order between the saturation pulses and the acquisition of the repetition steps is maintained during all m repetition steps, wherein the sequence of the individual spatial encoding steps and of the allocation of the N acquisitions of the differently spatially encoded signals, which act on the individual slices, to the respective slices is varied.

3. Method according to claim 1, **characterized in that** a permutation of the chronological order of the saturation pulses is performed, wherein the chronological order of acquisition of the differently spatially encoded signals of the individual slices is maintained during the m acquisitions of the differently spatially encoded signals, and the time of application of the saturation pulses is shifted relative to the acquisitions of the differently spatially encoded signals of the individual slices.

4. Method according to any one of the preceding claims, **characterized in that** RF pulses and time-variant magnetic gradient fields are selected for spatial encoding according to the principle of the n-dimensional spatially resolved Fourier transformation method.

5. Method according to any one of the claims 1 through 4, **characterized in that** spin echo sequences are used.

6. Method according to any one of the preceding claims, **characterized in that** a gradient echo sequence is used which may be either a spoiled-FLASH, refocused FLASH, reversed FLASH or true-FISP.

7. Method according to any one of the claims 1 through 4, **characterized in that** RARE(TSE) sequences are used, such that several differently spatially encoded pieces of data are acquired in each individual step.

**Revendications**

1. Procédé d'imagerie par résonance magnétique (IRM) à plusieurs couches pour l'enregistrement de N couches (N > 1) d'un objet de mesure, où un enregistrement en m (m > 1) phases répétitives, chacune à codage spatial différencié, est appliqué pour la reconstitution graphique intégrale, avec une préparation de saturation sous la forme d'une impulsion de saturation sélective de décalage (=décalage chimique), appliquée P fois (1 ≤ P < N) lors de chaque phase répétitive, si bien qu'au moyen de chacune de ces impulsions de saturation sélective de décalage chimique P, le signal est complètement supprimé avec le décalage chimique correspondant dans une tranche correspondante, et que les signaux de N-P couches ne sont par conséquent qu'incomplètement saturés,

   **caractérisé en ce que**

   la succession temporelle des impulsions de saturation et/ou l'ordre d'enregistrement des signaux différemment codés spatialement des différentes couches sont permutés, les signaux à codage spatial identique étant enregistrés pour chaque couche dans le même état de la préparation de saturation.

2. Procédé selon la revendication 1, **caractérisé en ce qu'**une permutation de l'ordre d'enregistrement des signaux différemment codés spatialement des différentes couches est exécutée, le schéma du déroulement temporel entre les impulsions de saturation et l'enregistrement des phases répétitives étant conservé pendant la totalité des m phases répétitives, la succession des différentes phases de codage spatial ainsi que l'affectation aux couches correspondantes des N enregistrements des signaux différemment codés spatialement, intervenant sur les différentes couches, étant toutefois variées.

3. Procédé selon la revendication 1, **caractérisé en ce qu'**une permutation la succession temporelle des impulsions de saturation est exécutée, le déroulement temporel de l'enregistrement des signaux différemment codés spatialement des différentes couches étant conservé pendant les m enregistrements des signaux différemment codés spatialement, et le moment d'application des impulsions de saturation étant décalé relativement aux enregistrements des signaux différemment codés spatialement des différentes couches.

4. Procédé selon l'une des revendications précédentes, **caractérisé en ce que** des impulsions HF et des champs magnétiques à gradient temporellement variables sont choisis pour le codage spatial suivant le principe de la transformation de Fourier à résolution spatiale à n dimensions.

5. Procédé selon l'une des revendications 1 à 4, **caractérisé par** l'application de séquences d'écho de spin.

6. Procédé selon l'une des revendications précédentes, **caractérisé par** l'application d'une séquence en écho gradient, pouvant être réalisée comme séquence de type spoiled FLASH, refocused FLASH, reversed FLASH ou true FISP.

7. Procédé selon l'une des revendications 1 à 4, **caractérisé par** l'application de séquences RARE (TSE) permettant d'enregistrer plusieurs données différemment codées spatialement lors de chaque phase distincte.

A) 

$k_y$

m

0

-m

1 2 3 ............... N

cs

PN

P3

P2

P1

B)

$k_y$

m

SN

0

-m

S2

S1

1 2 3 ............. N

cs

**FIG.1**

A)

$k_y$

m

0

-m

1 2 3 ............. N cs

B)

$k_y$

m

0

-m

1 2 3 ............. N cs

P3

P2

P1

**FIG.2**

**FIG.3**

**FIG.4**

FIG.5